Europäisches Patentamt

European Patent Office

Office européen des brevets

(11) Veröffentlichungsnummer: **0 330 984 B1**

(12) **EUROPÄISCHE PATENTSCHRIFT**

(45) Veröffentlichungstag der Patentschrift: **18.05.94**

(51) Int. Cl.5: **H03H 11/34**, H03L 7/08

(21) Anmeldenummer: **89103058.7**

(22) Anmeldetag: **22.02.89**

(54) **Split-Loop-Filter.**

(30) Priorität: **01.03.88 DE 3806461**

(43) Veröffentlichungstag der Anmeldung:
**06.09.89 Patentblatt 89/36**

(45) Bekanntmachung des Hinweises auf die
Patenterteilung:
**18.05.94 Patentblatt 94/20**

(84) Benannte Vertragsstaaten:
**AT CH DE ES FR GB LI**

(56) Entgegenhaltungen:
EP-A- 0 330 983
US-A- 4 032 852
US-A- 4 138 615

THE RADIO & ELECTRONIC ENGINEER, Band
50, Nr. 6, Juni 1980, Seiten 291-296, Institution of Electronic and Radio Engineers, London, GB; M.J. UNDERHILL: "Wide range frequency synthesizers with improved dynamic
performance"

(73) Patentinhaber: **AEG MOBILE COMMUNICATION
GmbH
Wilhelm-Runge-Strasse 11
D-89081 Ulm(DE)**

(72) Erfinder: **Kubetzko, Dietrich, Dipl.-Ing.
Klosterstrasse 31
D-7915 Elchingen 3(DE)**

(74) Vertreter: **Körner, Ekkehard, Dipl.-Ing. et al
Patentanwalt
Maximilianstrasse 58
D-80538 München (DE)**

EP 0 330 984 B1

**Beschreibung**

Die Erfindung betrifft ein Split-Loop-Filter gemäß dem Oberbegriff des Patentanspruchs 1.

Filter dieser Art werden beispielsweise als Schleifenfilter in Phasenregelschleifen mit spannungsgesteuerten Oszillatoren (VCOs) eingesetzt, die in der digitalen Frequenzaufbereitung als Synthesizer eingesetzt werden.

Synthesizer dieser Art sind seit langem bekannt. Sie enthalten, wie den Figuren zu entnehmen ist, einen spannungsgesteuerten Oszillator 2, der in an sich bekannter Weise über eine Phasenregelschleife 1, 3 und 4 in seiner Phase und damit in seiner Frequenz $f_{VCO}$ geregelt bzw. stabilisiert wird.

Die Phasenregelschleife besteht dabei aus einem Phasendetektor 4, einem Schleifenfilter 1 und gegebenenfalls aus einem Frequenzteiler 3. Der Phasendetektor 4 vergleicht die Phase eines Referenzsignals der Frequenz $f_R$ mit der Phase des Oszillatorsignals, dessen Frequenz $f_{VCO}$ gegebenenfalls durch den Frequenzteiler 3 zuvor durch N dividiert wird (wie dies beispielhaft in den Figuren angenommen worden ist). Weichen die Phasen der beiden Signale voneinander ab, erzeugt der Phasendetektor ein entsprechendes Korrektursignal, das über das Schleifenfilter 1 als Steuersignal in den spannungsgesteuerten Oszillator 2 eingespeist wird und dort die Phase des Oszillatorsignals entsprechend nachstimmt, bis die Phasen der beiden Signale im Phasendetektor innerhalb eines zulässigen Fehlers gleich sind.

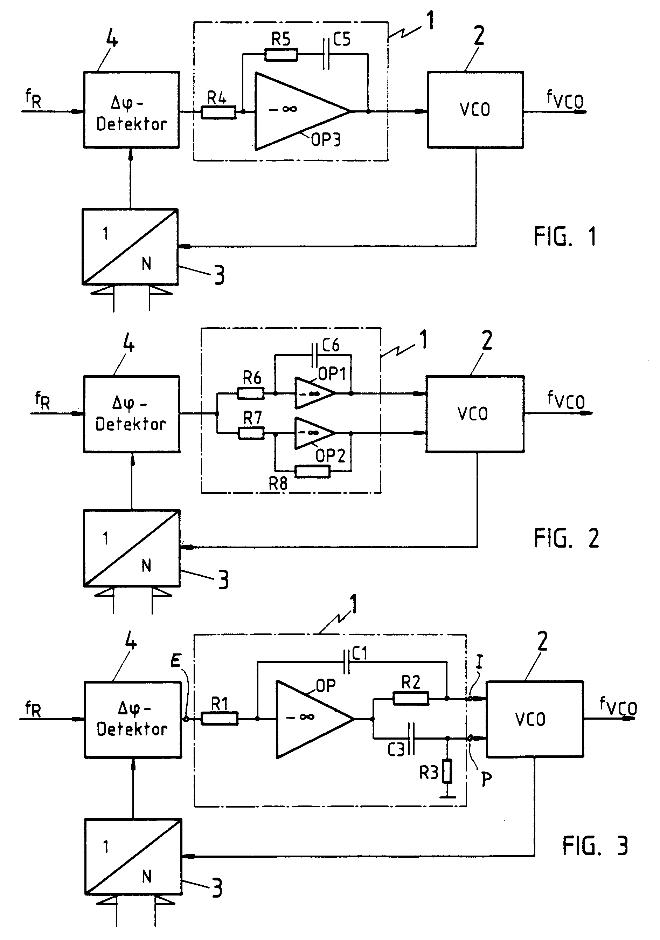

Der spannungsgesteuerte Oszillator 2 des bekannten Synthesizers in FIG. 1 wird dabei mit einer als PI-Regler ausgelegten Phasenregelschleife zweiter Ordnung mit einem einfachen Schleifenfilter in seiner Phase geregelt.

Das Schleifenfilter 1 besteht dabei aus einem Operationsverstärker OP3, dessen invertierender Eingang zum einen über einen ersten Widerstand R4 mit dem Ausgang des Phasendetektors 4 und zum anderen über eine Reihenschaltung aus zweitem Widerstand R5 und Kondensator C5 mit dem Ausgang rückgekoppelt und mit dem Steuereingang des spannungsgesteuerten Oszillators 2 verbunden ist.

Mit dieser bekannten Anordnung treten in der Praxis immer dann Schwierigkeiten auf, wenn es darum geht, eine digitale Frequenzaufbereitung zu realisieren, die zum einen eine möglichst große relative Frequenzvariation, d.h. eine möglichst große Kanalzahl, und zum anderen möglichst kurze Fequenzwechselzeiten für den gesamten Frequenzvariationsbereich ermöglicht, da die Schleifenparameter, die bekanntermaßen für das dynamische Verhalten der Regelschleife verantwortlich sind, über den Frequenzvariationsbereich so stark variieren, daß i.a. kein brauchbarer Kompromiß bezüglich der Dimensionierung der Regelschleife zu finden ist.

Mit einem Synthesizer nach FIG. 2, auf den sich im übrigen auch der Patentanspruch 1 in seinem Oberbegriff bezieht, können die vorgenannten Probleme weitgehend behoben werden. Das dort gezeigte Schleifenfilter 1 ist ebenfalls bekannt und wird allgemein als Split-Loop-Filter bezeichnet, da die Phasenregelschleife zwischen Phasendetektor 4 und Oszillator 1 in zwei Zweige aufgeteilt ist, wobei das Schleifenfilter 1 in einen Proportionalzweig R7, R8, OP2 und einen Integralzweig R6, C6, OP1 aufgespalten ist. Der spannungsgesteuerte Oszillator 1 benötigt bei dieser bekannten Lösung zwei Steuereingänge, deren Eigenschaften sich über den Frequenzvariationsbereich gerade nur so ändern, daß das dynamische Verhalten der Regelschleifen 1, 3, 4 weitgehend unabhängig von der momentan eingestellten Frequenz $f_{VCO}$ des Oszillators 1 ist. Der Nachteil dieser bekannten Lösung besteht vor allem darin, daß zwei Operationsverstärker im Schleifenfilter 1 benötigt werden, die zum Erreichen der zuvor genannten Eigenschaften auch noch mit ca. 30V zu betreiben sind.

Dieses wirkt sich nachteilig auf die Energiebilanz aus, insbesondere in der Anwendung eines solchen Synthesizers in tragbaren Funksprechgeräten, da diese ihre Engerie in aller Regel aus Batterien beziehen.

Aus der Fachzeitschrift "The Radio and Electronic Engineer", Band 50, Nr. 6, Seiten 291 bis 296, Juni 1980 ist ein Split-Loop-Synthesizer mit nur einem Operationsverstärker im Loop-Filter bekannt, der im Integralzweig liegt, während der Proportionalzweig lediglich über einen Ohm'schen Spannungsteiler zum zugeordneten Eingang des VCO führt. Daher kann in diesem Zweig nur gedämpft, nicht aber verstärkt werden. Die Anwendung der Schaltung ist dadurch sehr stark eingeschränkt, da sich mit ihr nur in wenigen Sonderfällen das dynamische Verhalten des Synthesizers ausreichend optimieren läßt.

Der Erfindung liegt die Aufgabe zugrunde, ein Split-Loop-Filter der eingangs genannten Art zu schaffen, der für seinen Betrieb möglichst wenig Energie benötigt und mit wenigen Bauteilen aufzubauen ist.

Die erfindungsgemäße Lösung ist im Patentanspruch 1 beschrieben. Die Unteransprüche enthalten vorteilhafte Ausund Weiterbildungen sowie bevorzugte Anwendungen der Erfindung.

Die Vorteile der erfindungsgemäßen Lösung bestehen vor allem darin, daß das Filter weitaus weniger Energie für seinen Betrieb benötigt als das bekannte Split-Loop-Filter gemäß FIG. 2 und wenig material- und damit kostenaufwendig ist.

Dies führt insbesondere dazu, daß mit dem erfindungsgemäßen Split-Loop-Filter Synthesizer mit einer großen relativen Frequenzvariation, d.h. großer Kanalzahl und mit sehr kurzen Frequenzwechselzeiten innerhalb des gesamten Frequenzvariationsbereichs, aufgebaut werden können, die sich wegen ihres sehr geringen Energie- und Platzbedarfs insbesondere für den Einsatz in tragbaren Funksprechgeräten eignen.

Im folgenden wird die Erfindung anhand der Figuren näher erläutert. Es zeigen

FIG. 1    den bereits diskutierten, bekannten Synthesizer mit einem einfachen Schleifenfilter in der Phasenregelschleife;

FIG. 2    den anderen bereits diskutierten, bekannten Synthesizer mit einem Split-Loop-Filter als Schleifenfilter in der Phasenregelschleife;

FIG. 3    den an sich bekannten Synthesizer gemäß FIG. 2 mit einer vorteilhaften Ausführungsform des erfindungsgemäßen Split-Loop-Filters als Schleifenfilter in der Phasenregelschleife;

FIG. 4    eine detaillierte Darstellung der Ausführungsform des erfindungsgemäßen Split-Loop-Filters gemäß FIG. 3.

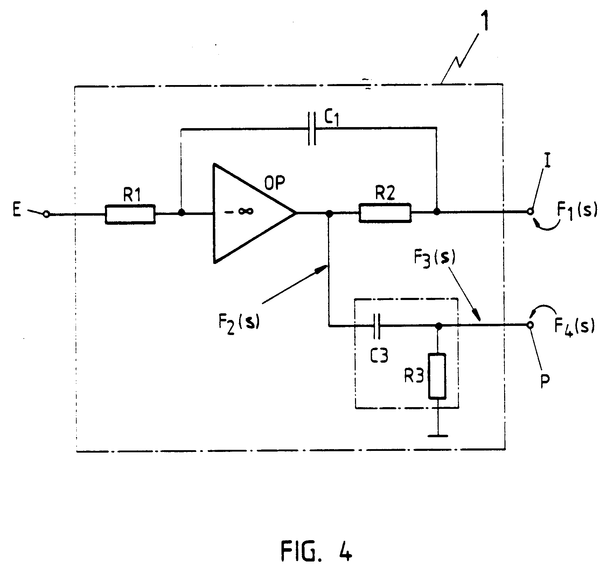

Das erfindungsgemäße Split-Loop-Filter 1 in den FIG. 3 und 4 besteht aus einem Operationsverstärker OP, der mit seinem Eingang zum einen über einen ersten Widerstand R1 an den Ausgang des an sich bekannten Phasendetektors 4 angeschlossen ist und zum anderen über einen ersten Kondensator C1 an den ersten Ausgang I des Split-Loop-Filters 1 angeschlossen ist, der den Ausgang des Integralzweiges des Filters 1 bildet.

Ausgangsseitig ist der Operationsverstärker OP zum einen über einen zweiten Widerstand R2 ebenfalls an den ersten Ausgang I des Filters 1 angeschlossen und zum anderen über einen zweiten Kondensator C3 an den zweiten Ausgang P des Filters 1, der den Ausgang des Proportionalzweiges des Filters 1 bildet. Die Verbindung des zweiten Kondensators C3 mit dem zweiten Ausgang P des Filters 1 ist dabei über einen dritten Widerstand R3 an Masse angeschlossen.

Die beiden Ausgänge P und I des Filters 1 sind in an sich bekannter Weise mit den entsprechenden Steuereingängen eines spannungsgesteuerten Oszillators 1 verbunden, der seinerseits (gegebenenfalls über einen 1:N-Frequenzteiler 3) mit dem Phasendetektor 4 verbunden ist. Der Phasendetektor 4 vergleicht in an sich bekannter Weise die Phase des Oszillatorsignals (gegebenenfalls die des in seiner Frequenz $f_{VCO}$ durch N dividierten Oszillatorsignals) mit der eines Referenzsignals der Frequenz $f_R$ und bildet bei Nichtübereinstimmung der beiden Phasen ein entsprechendes Steuersignal ab, das über das als Schleifenfilter wirkende erfindungsgemäße Split-Loop-Filter 1 in Form zweier Steuersignale den beiden Steuereingängen des Oszillators 1 zugeführt wird, wodurch die Phase des Oszillatorsignals entsprechend solange nachgestimmt wird, bis der Phasendetektor 4 innerhalb eines zulässigen Fehlers keine Abweichung der beiden Phasen von einander mehr feststellt.

Daß das erfindungsgemäße Split-Loop-Filter tatsächlich die gleiche Übertragungsfunktion F(s) wie das bekannte Split-Loop-Filter gemäß FIG. 2 hat, folgt aus folgender Ableitung:

Für die Übertragungsfunktion F(s) des erfindungsgemäßen Split-Loop-Filters gilt

$$F(s) = F_1(s) + F_4(s) \qquad (1)$$

mit

$$F_4(s) = F_2(s) \cdot F_3(s), \qquad (2)$$

wobei

$$F_2(s) = - \frac{s R_2 C_1 + 1}{s R_1 C_1} \qquad (3)$$

und

$$F_3(s) = \frac{s R_3 C_3}{s R_3 C_3 + 1} \qquad (4)$$

3

ist. $F_1(s)$ ist die Übertragungsfunktion des Integralzweiges und $F_4(s)$ die des Proportionalzweiges, wobei sich $F_4(s)$ multiplikativ aus den Übertragungsfunktionen $F_2(s)$ und $F_3(s)$ ergibt, die sich auf verschiedene Baugruppen des erfindungsgemäßen Filters 1 beziehen (vgl. FIG. 4).

Für den Proportionalzweig ergibt sich als Bedingung unter Berücksichtigung der Gleichungen (2) bis (4):

$$F_4(s) = - \frac{(sR_2C_1+1)}{s\,R_1\,C_1} \cdot \frac{s\,R_3\,C_3}{(sR_3C_3+1)} = konst. \qquad (5)$$

Es muß also gelten:

$$F_4(s) = konstant \qquad (6)$$

Darum ergeben sich mit den Grenzwerten für $F_4(O)$ bzw. $F_4(\infty) = - R_2/R_1$ die Randbedingungen zur Dimensionierung des Proportionalzweiges des Split-Loop-Filters zu:

$$R_2 \cdot C_1 = R_3 C_3 \qquad (7)$$

$$V_{prop} = - \frac{R_2}{R_1}, \qquad (8)$$

wobei $V_{prop}$ die Verstärkung zum Ausgang P, d.h. des Proportionalzweiges, ist.

Unter diesen Bedingungen gilt für die Übertragungsfunktion $F(s)$ des Filters nach FIG. 4

$$F(s) = F_1(s) + F_4(s) = - \frac{1}{sC_1R_1} + \frac{R_2}{R_1} \qquad (9)$$

Das entspricht exakt der Übertragungsfunktion des Filters nach FIG. 2.

Es versteht sich, daß die erfindungsgemäße Lösung mit fachmännischem Können und Wissen aus- und weitergebildet werden kann, ohne daß dies hier an dieser Stelle näher erläutert werden müßte.

So ist es in der Praxis vorteilhaft, den beiden Ausgängen P und I des erfindungsgemäßen Filters noch Tiefpässe bzw. Kerbfilter nachzuschalten, die eine zusätzliche Dämpfung der störenden Reste des Referenzsignals bewirken, ohne das dynamische Verhalten des Regelkreises zu beeinträchtigen.

Ferner ist es möglich, den zuvor genannten, dem Proportionalausgang P nachgeschalteten Tiefpaß oder Kerbfilter durch einen Kondensator zu ersetzen, der dann dem Widerstand R2 in FIG. 4 parallel zu schalten ist. Mit dieser Maßnahme ist es dann möglich, einen Split-Loop dritter Ordnung zu realisieren.

**Patentansprüche**

**1.** Split-Loop-Filter mit einem Proportionalzweig und einem Integralzweig, die einen gemeinsamen Eingang (E) und getrennte Ausgänge (P,J) aufweisen, und mit einem Operationsverstärker (OP) <u>dadurch gekennzeichnet</u>, daß

- der Eingang des Operationstärkers (OP) über einen ersten Widerstand (R1) an den Eingang (E) des Filters (1) und über einen ersten Kondensator (C1) an den ersten Ausgang (I) des Filters (1) angeschlossen ist;
- der Ausgang des Operationsverstärkers (OP) über einen zweiten Widerstand (R2) an den ersten Ausgang (I) des Filters (1) und über einen zweiten Kondensator (C3) an den zweiten Ausgang (P) des Filters (1) angeschlossen ist;
- die Verbindung zwischen zweitem Kondensator (C3) und zweitem Ausgang (P) des Filters (1) über einen dritten Widerstand (R3) an Masse angeschlossen ist und

- der erste Ausgang (I) des Filters (1) der Ausgang des Integralzweiges ist und der zweite Ausgang (P) des Filters (1) der Ausgang des Proportionalzweiges ist.

**2.** Split-Loop-Filter nach Anspruch 2, dadurch gekennzeichnet, daß das Produkt aus $R_2 \cdot C_1$ gleich oder zumindest annähernd gleich ist dem Produkt aus $R_3 \cdot C_3$ und daß die Verstärkung am zweiten Ausgang (P) des Filters (1) gleich $R_2/R_1$ ist.

**3.** Split-Loop-Filter nach Anspruch 1 oder 2, gekennzeichnet durch die Verwendung als Schleifenfilter (1) in einem Phasenregelkreis (1, 3, 4) mit einem spannungsgesteuerten Oszillator VCO (2) mit einem Steuereingang zum Anschluß des Integralzweiges des Filters (1) und mit einem weiteren Steuereingang zum Anschluß des Proportionalzweiges des Filters (1).

**4.** Split-Loop-Filter nach Anspruch 3, gekennzeichnet durch die Anwendung als Teil einer digitalen Frequenzaufbereitung (Synthesizer).

**5.** Split-Loop-Filter nach Anspruch 4, gekennzeichnet durch die Anwendung als Teil eines tragbaren Funksprechgerätes.

**Claims**

**1.** A split-loop filter including a proportional branch and an integral branch having a common input (E) and separate outputs (P, I), and an operation amplifier (OP),
characterized in that the input of said operation amplifier (OP) is connected to said input (E) of said filter (1) through a first resistor (R1), and to the first output (I) of said filter (1) through a first capacitor (C1),
the output of said operation amplifier (OP) is connected to said first output (I) of said filter (1) through a second resistor (R2), and to the second output (P) of said filter (1) through a second capacitor (C3),
the junction between said second capacitor (C3) and said second output (P) of said filter (1) is connected to ground through a third resistor (R3), and
said first output (I) of said filter (1) is the output of its integral branch, said second output (P) of said filter (1) being the output of its proportional branch.

**2.** A split-loop filter according to claim 1, characterized in that the product of $R_2 \cdot C_1$ is equal or at least approximately equal to the product of $R_3 \cdot C_3$, and that the amplification at said second output (P) of said filter (1) is equal to $R_2/R_1$.

**3.** A split-loop filter according to claim 1 or 2, characterized by its use as a loop filter (1) in a phase control circuit (1, 3, 4) including a voltage-controlled oscillator VCO (2) having a control input for connection to said integral branch of said filter (1), and a further control input for connection to said proportional branch of said filter (1).

**4.** A split-loop filter according to claim 3, characterized by its use as part of a digital freqency processor (synthesizer).

**5.** A split-loop filter according to claim 4, characterized by its use as part of a portable radiophone.

**Revendications**

**1.** Filtre split-loop (à boucle scindée), comprenant une branche proportionnelle et une branche d'intégration, qui comportent une entrée (E) commune et des sorties (P, I) séparées, et un amplificateur opérationnel (OP), caractérisé en ce que :
- l'entrée de l'amplificateur opérationnel (OP) est raccordée à l'entrée (E) du filtre (1) par l'intermédiaire d'une première résistance (R1) et à la première sortie (I) du filtre (1) par l'intermédiaire d'un premier condensateur (C1),
- la sortie de l'amplificateur opérationnel (OP) est raccordée à la première sortie (I) du filtre (1) par l'intermédiaire d'une deuxième résistance (R2) et à la seconde sortie (P) du filtre (1) par l'intermédiaire d'un second condensateur (C3),

- la jonction entre le second condensateur (C3) et la seconde sortie (P) du filtre (1) est raccordée à la masse par l'intermédiaire d'une troisième résistance (R3) et
- la première sortie (I) du filtre (1) constitue la sortie de la branche d'intégration et la seconde sortie (P) du filtre (1) constitue la sortie de la branche proportionnelle.

2. Filtre split-loop (à boucle scindée) suivant la revendication 1 ,.caractérisé en ce que le produit $R_2 . C_1$ est égal ou au moins approximativement égal au produit $R_3 . C_3$ et en ce que le gain à la seconde sortie (C) du filtre (1) est égal à $R_2/R_1$ .

3. Filtre split-loop (à boucle scindée) suivant l'une des revendications 1 et 2, caractérisé par son utilisation en tant que filtre de boucle (1) dans un circuit de réglage de phase (1, 3, 4) comprenant un oscillateur commandé en tension VCO (2) comportant une entrée de commande pour la connexion de la branche d'intégration du filtre (1) et une autre entrée de commande pour la connexion de la branche proportionnelle du filtre (1).

4. Filtre split-loop (à boucle scindée) suivant la revendication 3, caractérisé par son utilisation en tant que partie d'une mise en forme numérique de fréquence (synthétiseur).

5. Filtre split-loop (à boucle scindée) suivant la revendication 4, caractérisé par son utilisation en tant que partie d'un poste émetteur-récepteur portatif (talkie-walkie).

FIG. 1

FIG. 2

FIG. 3

FIG. 4